# EUROPÄISCHE PATENTANMELDUNG

(11) **EP 2 136 395 A2**
(43) Veröffentlichungstag der Anmeldung: **23.12.2009**
(21) Anmeldenummer: 09006890.9
(22) Anmeldetag: 22.05.2009
(51) Int. Cl.: H01L 21/673

(54) **Wafermagazin**

(30) Priorität: 20.06.2008 DE 102008030629
(71) Anmelder: ACI-Ecotec Gmbh & Co. Kg, 78112 St. Georgen (DE)
(72) Erfinder: Jäger, Felix, 78333 Stockach (DE)
(74) Vertreter: Fuhlendorf, Jörn

(57) **Zusammenfassung**

Ein Wafermagazin (10) für fotovoltaische Zellen besitzt einen Grundkörper (12), eine auf den Grundkörper (12) aufliegenden Grundplatte (11), die gegenüber dem Grundkörper (12) senkrecht zu dessen und ihrer Grundfläche bewegbar ist und die der Aufnahme der waferförmigen Gegenstände dient, und im Bereich jeder der Seiten des Grundkörpers (12) angeordnete und an diesem gehaltene Führungseinheiten (13, 14), die die Grundplatte (11) umgeben und der Bewegungsführung der auf die Grundplatte (11) zu legenden oder auf dieser liegenden waferförmigen Gegenstände dienen. Zur Reduzierung der Gefahr von Kantenbrüchen der Wafer insbesondere beim Entnehmen auf ein Minimum ist vorgesehen, dass jede Führungseinheit mindestens eine starr am Grundkörper (12) befestigte, aufrechte Führungsstange (13, 14) aufweist, zwischen der und dem Außenumfang der Grundplatte (11) ein vorzugsweise umlaufender bandförmiger Puffer (40) vorgesehen ist, der mit der Grundplatte (11) bewegungsschlüssig gekoppelt ist und der mit seiner Innenseite (53) an der der Grundplatte (11) zugewandten Innenseite (51) jeder Führungsstange (13, 14) unmittelbar anliegt.

## Beschreibung

Die vorliegende Erfindung bezieht sich auf ein Wafermagazin für waferförmige Gegenstände, insbesondere fotovoltaische Zellen nach dem Oberbegriff des Anspruchs 1.

Wafermagazine dienen zum Bereitstellen beispielsweise fotovoltaischer Zellen zu Bearbeitungsstationen für Automatisierungsprozesse, wobei das Wafermagazin beispielsweise mittels eines Transportsystems zu und von den Stationen verfahrbar ist.

Bei einem Wafermagazin der eingangs genannten Art, wie es aus der DE 10 2005 033859 B3 bekannt geworden ist, sind die Führungseinheiten durch Führungsbänder gebildet, die an einer oder um eine Begrenzungsstruktur in Form jeweils eines Begrenzungsholms bewegbar und dabei von der benachbarten Innenseite des betreffenden aufrechten Begrenzungsholms beabstandet angeordnet sind. Diese Abstände der sogenannten Führungsbänder von den starren aufrechten Begrenzungsholmen führen zu einer Flexibilität der Führungsbänder quer zur Bewegungsrichtung der Führungsbänder bzw. Verfahrrichtung der Grundplatte, also in Richtung der Ebene der im Wafermagazin angeordneten waferförmigen Gegenstände. Es hat sich herausgestellt, dass diese Flexibilität der Führungsbänder eher nachteilig ist, da sich auf diese Weise die Führungsbänder in eine vertikale Ebene bewegen lassen, die in Richtung der Innenseite des jeweiligen aufrechten Begrenzungsholmes hinter die senkrechte Ebene des Außenumfangs der Umlenkrollen für das betreffende Führungsband gelangt, was zur Folge hat, dass an den waferförmigen Gegenständen Kantenbruch dann auftreten kann, wenn diese in den Bereich der oberen Umlenkrolle gelangen und von unten mehr oder weniger auf diese treffen.

Aufgabe der vorliegenden Erfindung ist es deshalb, ein Wafermagazin der eingangs genannten Art zu schaffen, bei dem die Gefahr von Kantenbruch der Wafer insbesondere beim Entnehmen auf ein Minimum reduziert, wenn nicht gar vermieden ist.

Zur Lösung dieser Aufgabe sind bei einem Wafermagazin für waferförmige Gegenstände insbesondere fotovoltaische Zellen der genannten Art die im Anspruch 1 angegebenen Merkmale vorgesehen.

Durch die erfindungsgemäßen Maßnahmen ist erreicht, dass sich dadurch, dass die Führungseinheiten durch starre Führungsstangen und durch bandförmige Puffer an der starren aufrechten Führungsstange anliegen, die waferförmigen Gegenstände sich nicht in Richtung quer zur Verfahr- bzw. Bewegungsrichtung bewegen können. Damit sind die fotovoltaischen Zellen in dieser Querrichtung unbeweglich geführt. Der bandförmige Puffer wirkt je nach Ausgestaltung hinsichtlich des Materials in dieser Querrichtung lediglich stoßmildernd.

Werden bei dem Wafermagazin die bandförmigen Puffer um eine obere und eine untere Umlenkrolle den Führungsstangen endlos umlaufend geführt, könnten die Umlenkrollen einen Durchmesser aufweisen, der gleich oder etwas kleiner als die entsprechende Breite der aufrechten Führungsstangen ist. Dies hat jedoch den Nachteil, dass der bandförmige Puffer auch an der Rückseite der aufrechten Führungsstange anliegt, was für das Spannen oder Nachspannen des umlaufenden bandförmigen Puffers nachteilig ist. Gemäß einem bevorzugten Ausführungsbeispiel vorliegender Erfindung sind deshalb die Merkmale nach Anspruch 2 vorgesehen, was auch zu verbesserten Eigenschaften des an der aufrechten Führungsstange anliegenden Trums des umlaufenden bandförmigen Puffers führt.

Mit den Merkmalen nach Anspruch 3 ist in bevorzugter Weise erreicht, dass sich der an der aufrechten Führungsstange anliegende Trum des umlaufenden bandförmigen Puffers im Bereich der insbesondere oberen Umlenkrolle in eine weiter zur Rückseite der aufrechten Führungsstange verlaufenden Ebene bewegt, was eine Verbesserung bzw. ungehinderte Entnahme der fotovoltaischen Zellen ermöglicht.

Vorteilhafte konstruktive Ausgestaltungen des Wafermagazins hinsichtlich Anordnung der Führungsstange und/oder der Umlenkrollen ergeben sich aus den Merkmalen eines oder mehrerer der Ansprüche 4 bis 7. Dabei ist gemäß den Merkmalen des Anspruchs 7 die Verstellbarkeit der oberen Umlenkrolle zum Einstellen bzw. Nachstellen der Spannung des bandförmigen Puffers von besonderem Vorteil.

Ist gemäß den Merkmalen nach Anspruch 8 der bandförmige Puffer durch einen Zahnriemen gebildet, kann die bewegungsschlüssige Verbindung des bzw. der Zahnriemen mit der Grundplatte in besonders einfacher und vorteilhafter Weise erreicht werden, wie dies aus den Merkmalen nach Anspruch 9 ersichtlich ist. Hierbei sind in vorteilhafter Weise die Merkmale nach Anspruch 10 miteinbezogen. Mit anderen Worten, während die Verbindung von Verbindungsleiste und Grundplatte beispielsweise mittels Schrauben erfolgt, ist der Bewegungsschluss von Verbindungsleiste und Zahnriemen in einfacher Weise durch eine Art Steckverbindung erreicht. Dabei können beliebige Bereiche des Zahnriemens für die Bewegungsschlüssigkeit ausgewählt werden. Um ein möglichst unmittelbares Anlegen des Zahnriemens an die Führungsstange auch im Bereich der Verbindungsleiste zu gewährleisten, sind in vorteilhafter Weise dabei die Merkmale nach Anspruch 11 vorgesehen.

Statt einer Auf- und Abbewegung der Grundplatte mittels deren Unterseite angreifender Stempel ist gemäß den Merkmalen nach Anspruch 12 ein reversibles Antreiben einiger oder aller unteren Umlenkrollen vorgesehen.

Weitere Einzelheiten der Erfindung sind der folgenden Beschreibung zu entnehmen, in der die Erfindung anhand des in der Zeichnung dargestellten Ausführungsbeispieles näher beschrieben und erläutert ist. Es zeigen:

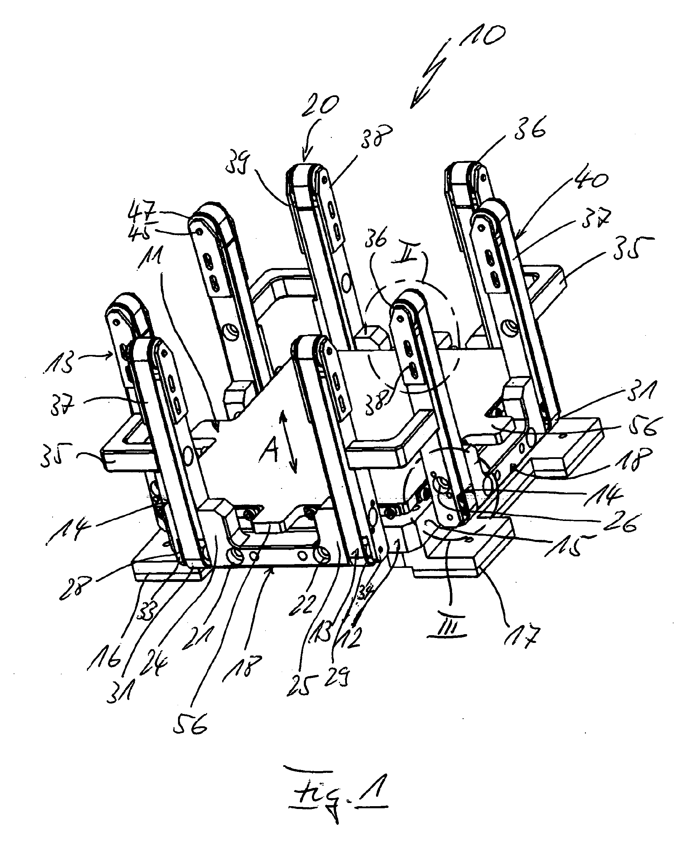

- Figur 1: in perspektivischer Darstellung ein Wafermagazin zur Handhabung fotovoltaischer Zellen gemäß einem bevorzugten Ausführungsbeispiel vorliegender Erfindung,

- Figur 2: in vergrößerter Darstellung eine Teilansicht gemäß Kreis II der Figur 1,
- Figur 3: in vergrößerter Darstellung eine Teilansicht gemäß Kreis III der Figur 1 und
- Figur 4: einen Schnitt längs der Linie IV-IV der Figur 3.
- Figur 5: einen vergrößerten Schnitt längs der Linie V-V der Figur 4.

Das in der Zeichnung dargestellte Wafermagazin 10 dient zur Aufnahme von nicht im einzelnen dargestellten waferförmigen Gegenständen, insbesondere von fotovoltaischen Zellen und zum Transportieren dieser fotovoltaischen Zellen von und zu verschiedenen Bearbeitungsstationen zur Herstellung fotovoltaischer Elemente.

Das Wafermagazin 10 stellt im Wesentlichen einen oben offenen Käfig dar, in welchem die waferförmigen Gegenstände bzw. fotovoltaischen Zellen auf einer in Richtung des Doppelpfeils A bewegbaren bzw. verfahrbaren Grundplatte 11 angeordnet sind bzw. abgelegt und wieder entnommen werden. Das Wafermagazin 10 besitzt einen plattenförmigen hier quadratischen Grundkörper 12, an dem ringsum, das heißt an allen vier seiner rechteckförmig zueinander verlaufenden Seiten 15 aufrecht stehende Führungsstangen 13, 14 angeordnet sind. An jeder Seite 15 des Grundkörpers 12 sind jeweils zwei parallel zueinander angeordnete, im Querschnitt hier rechteckförmige Führungsstangen 13 und 14 befestigt. Der Grundkörper 12 ist auf zwei parallelen schienenartigen Trägern 16 und 17 befestigt, über die das Wafermagazin 10 mittels eines nicht dargestellten Transportssystems zwischen benachbarten Bearbeitungsstation bzw. Lade- oder Entladestationen verfahrbar ist.

Der beim dargestellten Ausführungsbeispiel quadratische Grundkörper 12 ist an allen Seiten 15 mit einem U-förmigen Träger 18 bestückt, der im Bereich seiner Bohrungen 21 und 22 an der Seitenkante 15 des Grundkörpers 12 beispielsweise mittels Schrauben befestigt ist. An den aufrechten Schenkeln 24 und 25 des U-förmigen Trägers 18 ist jeweils eine Führungsstange 13, 14 seitlich im Bereich einer Bohrung 26 schraubend befestigt.

In ihrem unteren Bereich ist jede Führungsstange 13, 14 mit einer Aussparung 28 bzw. 29 versehen, in welcher eine untere Umlenkrolle 31 drehbar gehalten ist, deren Achse 32 einenends in einer Seitenwange 33 bzw. 34 der Aussparung 28, 29 der Führungsstange 13, 14 und andernends im zugewandten Ende des horizontalen Verbindungsschenkels 23 des U-Trägers 18 gehalten ist. Die untere Umlenkrolle 31 ist Teil einer Führungsanordnung 20 für die auf die Grundplatte 11 zu legenden bzw. auf der Grundplatte liegenden waferförmigen Gegenstände bzw. fotovoltaischen Zellen.

Benachbarte Führungsstangen 13 und 14 an zwei benachbarten Seiten 15 des Grundkörpers 12 sind etwa in mittiger Höhe der aufrechten Führungsstangen 13, 14 über ein rechteckiges Winkelelement 35 miteinander fest verbunden.

Teile der Führungsanordnung 20 sind außer den Führungsstangen 13 und 14 bandförmige Pufferanordnungen 40, die jeweils aus einer unteren Umlenkrolle 31, einer oberen Umlenkrolle 36 sowie einem endlos umlaufenden bandförmigen Puffer 37 bestehen. Die obere Umlenkrolle 36 ist oberhalb des oberen Endes der Führungsstange 13, 14 angeordnet und dabei an zu beiden Seiten jeder Führungsstange 13, 14 angeordneten Stellplättchen 38 und 39 drehbar befestigt.

Die beiden Stellplättchen 38 und 39 sind über Langlöcher 41 und 42 mittels Schrauben 43 an den beiden Stirnseiten 44 der Führungsstange 13, 14 befestigt. Auf diese Weise sind die Stellplättchen 38 und 39 in ihrer Längsausrichtung und längs der Führungsstangen 13, 14 verstellbar, um ein Spannen oder auch Nachspannen des bandförmigen Puffers 37 zu erreichen. Das obere freie Ende jedes Stellplättchens 38, 39 ist von einer Achse 45 der oberen Umlenkrolle 36 durchdrungen. Beim dargestellten Ausführungsbeispiel ist der bandförmige Puffer als Zahnriemen 37 ausgebildet und die untere und die obere Umlenkrolle 31, 36 sind an ihrem Außenumfang mit entsprechend angeordneten achsparallelen Zahnlücken für die Zähne 46 des Zahnriemens 37 versehen. Beide Umlenkrollen 31 und 36 besitzen scheibenförmige Seitenwangen 47, die den den Zahnriemen 37 aufnehmenden Bereich in radialer Richtung übergreifen.

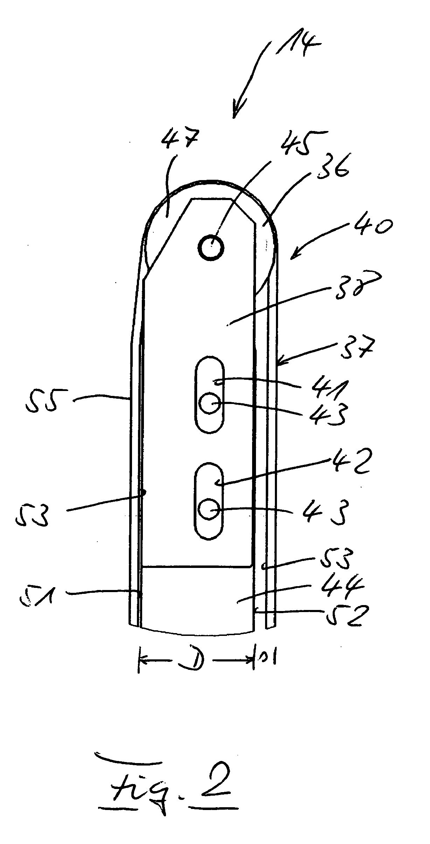

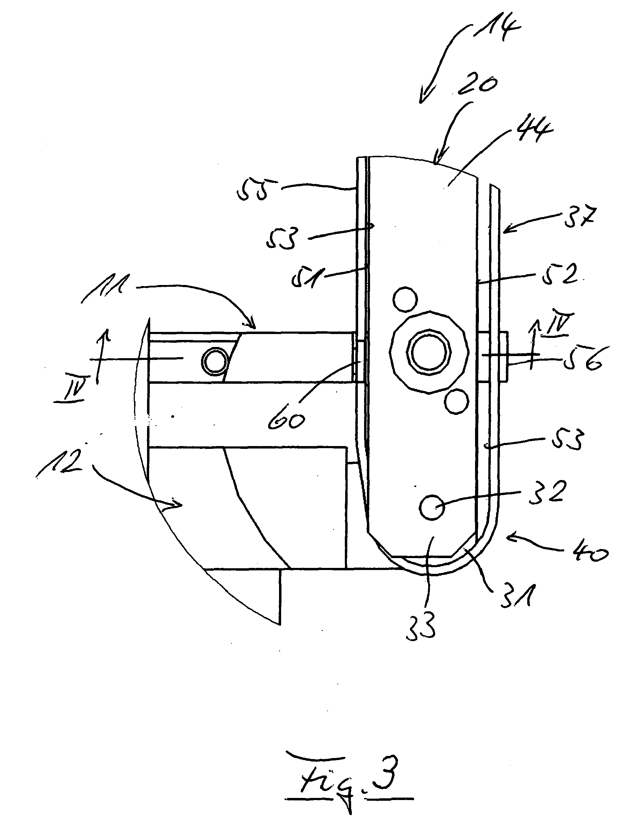

Der Durchmesser des den Zahnriemen 37 aufnehmenden Bereichs der Umlenkrollen 31 und 36 ist etwa gleich dem Abstand der Innenseite 51 und der Außenseite 52 voneinander also der Dicke der Führungsstange 13 bzw. 14, während der Durchmesser der Seitenwangen 47 größer ist. Die Achsen 32 und 45 sind hinsichtlich der Dicke D der Führungsstangen 13, 14 asymmetrisch angeordnet, und zwar derart, dass der Außenumfang der Seitenwangen 47 gegenüber der Innenseite 51 der Führungsstange 13, 14 leicht zurückgesetzt ist, während er gegenüber der Außenseite 52 der Führungsstange 13, 14 um ein Maß s übersteht. Dies bedeutet, dass, wie in Figur 2 dargestellt, die hier nicht im Detail dargestellte gezahnte Innenseite 53 des Zahnriemens 37 an der Innenseite 51 der Führungsstange 13, 14 anliegt, während sie gegenüber der Außenseite 52 einen vom Maß s abhängigen Abstand zur Außenseite 52 besitzt. Des weiteren ist erreicht, dass der der oberen Umlenkrolle 36 benachbarte Bereich 54 des vorderen Trums 55 des Zahnriemens 37 leicht schräg nach außen verlaufend geneigt ist, und zwar in einem Bereich oberhalb des freien Endes der Führungsstange 13, 14; entsprechendes gilt für den Verlauf des vorderen Trums 55 im Bereich der unteren Umlenkrolle 31, wie Figur 3 zu entnehmen ist.

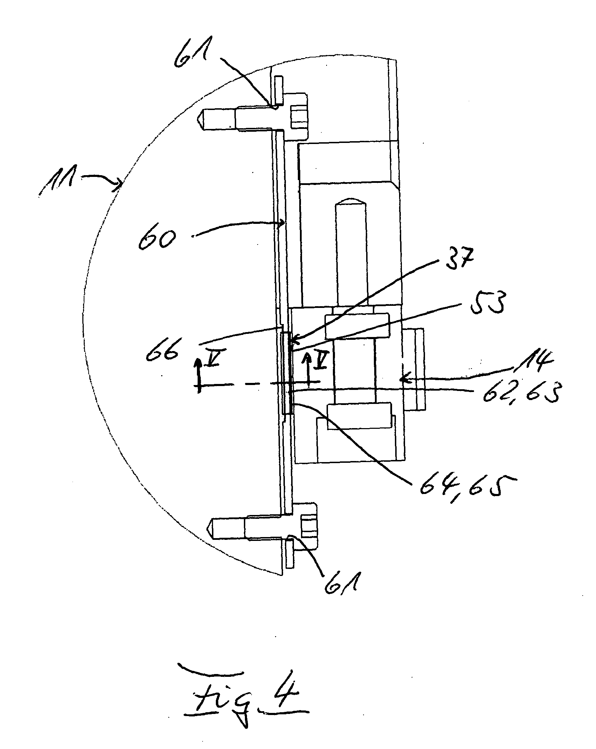

Die Grundplatte 11 besitzt grundsätzlich eine dem Grundkörper 12 entsprechende Form, ist jedoch dünner und gegenüber dem Grundkörper 12 in Richtung des Doppelpfeiles A verfahrbar angeordnet. Die Grundplatte 11 besitzt im Bereich der U-Träger 18 nasenartige Vorsprünge 56, die jeweils mittig einer Seite der Grundplatte 11 angeordnet sind und zwischen die U-Träger 18 ragen. Die Grundplatte 11 besitzt eine Grundfläche, die jeweils bis an die ungezahnten d.h. glatten Außenseiten der umlaufenden Zahnriemen 37 reicht. Die Grundplatte 11 ist mit den Zahnriemen 37 bewegungsschlüssig verbunden (Figur 4). Dazu ist an jedem Zahnriemen 37 eine Verbindungsleiste 60 bewegungsschlüssig gehalten, die quer zur Umlaufrichtung des Zahnriemens 37 angeordnet ist und die an beiden freien Enden mit Befestigungsbohrungen 61 versehen ist, über die die Verbindungsleiste 60 an die betreffenden Seitenbereiche der Grundplatte 11 festgeschraubt ist.

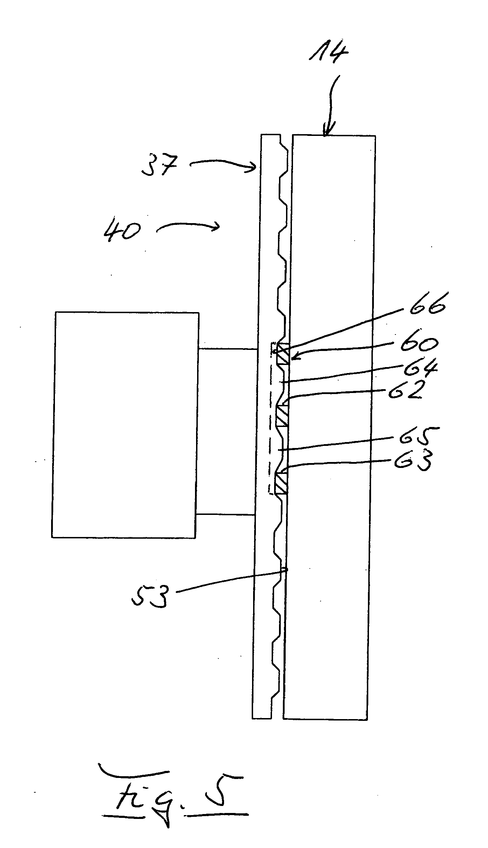

Wie aus den Figuren 4 und 5 ersichtlich ist, besitzt die Verbindungsleiste 60 beim Ausführungsbeispiel zwei parallele, sich in Längserstreckung der Verbindungsleiste 60 erstreckende Schlitze 62 und 63, durch die zwei benachbarte Zähne 64 und 65 der hier im Detail dargestellten Innenseite 53 des Zahnriemens 37 greifen. Die Verbindungsleiste 60 ist im Bereich der Schlitze 62, 63 mit einer der gezahnten Innenseite 53 des Zahnriemens 37 zugewandten offenen Nut 66 versehen, so dass in diesem Bereich die Verbindungsleiste 60 eine etwas geringere Dicke aufweist, die etwas größer als die Dicke der vorstehenden Zähne 64, 65 des Zahnriemens 37 ist. Auf diese Weise steht die an der Innenseite 51 der Führungsstange 13, 14 anliegende Innenfläche der Verbindungsleiste 60 gegenüber dem vorstehenden Zahn 64, 65 noch etwas vor. Damit ist gleichzeitig gewährleistet, dass der Zahnriemen 37 über im Wesentlichen die gesamte Länge des vorderen Trums 55 des umlaufenden Zahnriemens 37 anliegt. Die Verbindungsleiste 60 ist damit bewegungsschlüssig mit dem umlaufenden Zahnriemen 37 verbunden und kann an jeder Stelle der gezahnten Innenseite 53 des Zahnriemens 37 angebracht werden. Ein Herausrutschen der Verbindungsleiste 60 aus der gezahnten Innenseite 53 des Zahnriemens 37 ist wegen der vorbeschriebenen Abmessung der Grundplatte 11 gegenüber der Führungsanordnung 20 bzw. der Bandanordnung 40 nicht möglich.

Es versteht sich, dass das Wafermagazin 10 statt einer quadratischen Grundfläche auch eine beliebig andere Grundfläche, die dem Format bzw. der Grundfläche der fotovoltaischen Zellen entspricht, besitzen kann. Dabei sind dann eine entsprechende Führungsanordnung 20 und entsprechende Bandanordnungen 40 an entsprechenden Stellen des Grundkörpers vorzusehen.

Beim dargestellten Ausführungsbeispiel erfolgt die vertikale Bewegung gemäß Doppelpfeil A der Grundplatte 11 durch zwei Stempel, die von unten durch Bohrungen im Grundkörper 12 hindurch bewegt werden und auf die Unterseite der Grundplatte 11 treffen. Gemäß einem nicht dargestellten Ausführungsbeispiel wird die Auf- und Abbewegung der Grundplatte 11 dadurch vorgenommen, dass die unteren Umlenkrollen 31 alle oder teilweise über Wellen miteinander verbunden sind und über ein damit verbundenes Antriebssystem angetrieben werden.

An den Arbeitsstationen zum Be- und Entladen der Magazine werden diese einige mm ausgehoben und über unterhalb angebrachte Buchsen zentriert. Diese Auflagen, die vorwiegend für den Transport des Magazins angebracht sind, haben noch die Aufgabe, dass das Ausheben durch externe Niederhalter oder Vergleichbares begrenzt wird und somit eine exakte Positionierung des Magazins in einer Arbeitstation gegeben ist.

## Patentansprüche

1. Wafermagazin (10) für waferförmige Gegenstände, insbesondere fotovoltaische Zellen, mit:
einem Grundkörper (12),
einer auf den Grundkörper (12) aufliegenden Grundplatte (11), die gegenüber dem Grundkörper (12) senkrecht zu dessen und seiner Grundfläche bewegbar ist und die der Aufnahme der waferförmigen Gegenstände dient,
im Bereich jeder der Seiten des Grundkörpers (12) angeordneten und an diesem gehaltenen Führungseinheiten (13, 14), die die Grundplatte (11) umgeben und der Bewegungsführung der auf die Grundplatte (11) zu legenden oder auf dieser liegenden waferförmigen Gegenstände dienen,
**dadurch gekennzeichnet, dass** jede Führungseinheit mindestens eine starr am Grundkörper (12) befestigte, aufrechte Führungsstange (13, 14) aufweist, zwischen der und dem Außenumfang der Grundplatte (11) ein vorzugsweise umlaufender bandförmiger Puffer (40) vorgesehen ist, der mit der Grundplatte (11) bewegungsschlüssig gekoppelt ist und der mit seiner Innenseite (53) an der der Grundplatte (11) zugewandten Innenseite (51) jeder Führungsstange (13, 14) unmittelbar anliegt.

2. Wafermagazin nach Anspruch 1, **dadurch gekennzeichnet, dass** der bandförmige Puffer (40) um eine untere und eine obere Umlenkrolle (31, 36) an der Führungsstange (13, 14) endlos umlaufend angeordnet ist, und dass die obere und die untere Umlenkrolle (31, 36) einen gegenüber der Tiefe der Führungsstange (13, 14) größeren Durchmesser aufweisen und ihre Drehachsen (32, 45) gegenüber der Längsmittelebene der Führungsstange (13, 14) außermittig zur Außenseite (52) der Führungsstange (13, 14) versetzt sind.

3. Wafermagazin nach Anspruch 2, **dadurch gekennzeichnet, dass** der Auflageumfang der Umlenkrollen (31, 36) gegenüber der Innenseite (51) der Führungsstange (13, 14) vorzugsweise um die Dicke des bandförmigen Puffers (40) zurückgesetzt ist.

4. Wafermagazin nach mindestens einem der vorhergehenden Ansprüche, **dadurch gekennzeichnet, dass** die Führungsstangen (13, 14) am Umfangsrand des Grundkörpers (12) befestigt sind.

5. Wafermagazin nach Anspruch 4**, dadurch gekennzeichnet, dass** jeweils zwei Führungsstangen (13, 14) an gegenüberliegenden Enden eines an jeder Umfangsrandseite des Grundkörpers (12) befestigten vorzugsweise U-förmigen Halteelementes (18) befestigt sind.

6. Wafermagazin nach mindestens einem der vorhergehenden Ansprüche, **dadurch gekennzeichnet, dass** die Umlenkrollen (31, 36) jeweils am oberen bzw. unteren Ende der Führungsstange (13, 14)drehbar gehalten sind.

7. Wafermagazin nach mindestens einem der vorhergehenden Ansprüche, **dadurch gekennzeichnet, dass** die obere Umlenkrolle (36) an der Führungsstange (13, 14) in Richtung der Erstreckung des bandförmigen Puffers (40) verstellbar gehalten ist.

8. Wafermagazin nach mindestens einem der vorhergehenden Ansprüche, **dadurch gekennzeichnet, dass** der bandförmige Puffer (40) durch einen Zahnriemen (37) gebildet ist, und die Umlenkrollen (31, 36) außenumfangsseitig entsprechend verzahnt sind.

9. Wafermagazin nach den Ansprüchen 1 und 8, **dadurch gekennzeichnet, dass** der Zahnriemen (37) mit einer quer zu seiner Längserstreckung angeordneten Verbindungsleiste (60) bewegungsschlüssig verbunden ist, die an der Grundplatte (11) befestigbar vorzugsweise anschraubbar ist.

10. Wafermagazin nach Anspruch 9, **dadurch gekennzeichnet, dass** die Verbindungsleiste (60) mit mindestens einem Längsschlitz (62, 63) versehen ist, in den ein Zahn (64, 65) des Zahnriemens (37) eingreift.

11. Wafermagazin nach Anspruch 10, **dadurch gekennzeichnet, dass** die Verbindungsleiste (60) im Eingriffsbereich des Zahnriemens (37) eine der Tiefe des Zahns (64, 65) entsprechende Dicke aufweist.

12. Wafermagazin nach mindestens einem der Ansprüche 2 bis 11, **dadurch gekennzeichnet, dass** zumindest ein Teil der unteren Umlenkrollen (31) mit einem Antriebssystem in und gegen den Uhrzeigersinn antreibbar verbunden sind.
